# EUROPEAN PATENT SPECIFICATION

(11) **EP 3 505 006 B1**
(45) Date of publication and mention of the grant of the patent: **24.02.2021**
(21) Application number: 16913992.0
(22) Date of filing: 03.11.2016
(51) Int. Cl.: A45D 40/20, A45D 34/04

(54) **LIQUID EYELINER HAVING LIQUID STORAGE FUNCTION**
FLÜSSIGER EYELINER MIT FLÜSSIGKEITSSPEICHERFUNKTION
LIGNEUR LIQUIDE AYANT UNE FONCTION DE STOCKAGE DE LIQUIDE

(30) Priority: 25.08.2016 CN 201610723993
(43) Date of publication of application: 03.07.2019
(73) Proprietor: Shya Hsin Packaging Industry (China) Co., Ltd., Kunshan, Jiangsu 215301 (CN)
(72) Inventor: ZHONG, Hua, Kunshan, Jiangsu 215301 (CN); ZHAN, Linglang, Kunshan, Jiangsu 215301 (CN)
(74) Representative: Ipside
(86) International application number: PCT/CN2016/104482
(87) International publication number: WO 2018/035972

(56) References cited:
- CN-B- 102 132 993
- CN-U- 204 561 273
- CN-U- 204 561 275
- CN-U- 204 908 373
- CN-U- 205 162 264
- CN-U- 206 043 802
- JP-A- H11 139 470
- JP-A- 2015 080 856

## Description

### Technical Field

The invention relates to the technical field of liquid eyeliner, and in particular to a liquid eyeliner having a liquid storage function.

### Background of the Invention

Documents JP 2015 080856 A and CN 102132993 B disclose examples of known eyeliner applicators.

With the development of the economy and the improvement of people's living standards, people are paying more and more attention to their own image and health, especially the women, the probability and frequency of using cosmetics is getting bigger and bigger. Mascara brush, eyeliner, lip brush, etc. are all cosmetics that is commonly used by women.

However, when the existing eyeliner is used, it is often affected by temperature and pressure instability, which in turn affects the amount of bristles discharging, making the output of bristles to be unsteady.

In view of this, the present invention has been specifically proposed.

### Summary of the Invention

In order to overcome the above drawbacks, the present invention provides a liquid eyeliner having liquid storage function, which can effectively ensure the output stability of the bristles.

The technical solution adopted by the present invention to solve the technical problem thereof is: a liquid eyeliner having a liquid storage function, comprising a container component for containing the coating, a coating component for drawing and applying the eyeliner to the face of the user, and a cap component, wherein the coating component has a brush cover base, a brush cover, a diversion base, a connection, a diversion core, and bristles positioned and connected to one axial end of the diversion core; the brush cover base, the brush cover, the diversion base, and the connection being coaxially disposed, and all are sleeve-shaped structures that are open at both ends of the axial direction, and the rear axial end of the brush cover and the front axial end of the connection are respectively correspondingly positioned and inserted into the front and rear axial ends of the brush cover base, and the diversion base is disposed inside of the brush cover base, and located between the brush cover and the connection, and at the same time the two axial ends of the diversion base are also respectively abutted with the rear axial end of the brush cover and the front axial end of the connection; in addition, the brush cover, the diversion base, and the connection also collectively enclose a receiving cavity, the diversion core together with the bristles are all coaxial positioned and inserted into the receiving cavity, and a part of the bristles also protrudes outside the front axial end of the brush cover; also a circuit of a first convex edge extends radially outward at the outer side wall of the brush cover base; the first convex edge divides the brush cover base into a first portion corresponding to the connection, and a second portion corresponding to the brush cover, and the first portion of the brush cover base is inserted into the container component, and is in a detachable positioning connection with the container component; the cap component being detachably sleeved outside at the second portion of the brush cover base; the brush cover has a brush cover body, wherein the brush cover body is a sleeve-shaped structure that is open at both ends of the axial direction;
characterized in that
at least one air inlet orifice extending along the axial direction is formed at a position on the brush cover body near the front axial end, and the front side of the air inlet orifice is exposed outside the brush cover base; at least one first air exhaust groove extending along the axial direction is formed on the outer peripheral side wall of the brush cover body, and the front side of the first air exhaust groove is continuous with the air inlet orifice, and the rear side of the first air exhaust groove is continuous with a second exhaust groove on the diversion base;

In addition, at least one liquid storage groove unit is further disposed on an inner circumferential side wall of the brush cover body, and each of the liquid storage groove units is respectively composed of a plurality of circular arc-shaped liquid storage groove extending circumferentially along the brush cover body, and a plurality of circular arc-shaped liquid storage grooves in each of the liquid storage groove units are also arranged along the axial interval of the brush cover body.

As a further improvement of the present invention, two liquid storage groove units are provided, a plurality of arc-shaped liquid storage grooves of the two liquid storage groove units are symmetrically distributed around an axial center line of the brush cover body;

Two air inlet orifices are provided, and the two air inlet orifices are matched with the two liquid storage groove units in one-to-one correspondence, and each rear side of the air inlet orifice further respectively extends to the front side of the liquid storage groove unit corresponding thereto.

As a further improvement of the present invention, the exhaust groove is disposed outside at the two circumferential sides of each liquid storage groove unit, and the rear side of the two exhaust grooves are continuously connected to the second exhaust groove of the diversion base.

A circular arc-shaped interconnected pore extending along the circumferential direction of the brush cover body is further disposed at a position on the back side of each liquid storage groove unit on the brush cover body, and the rear side of the exhaust groove is connected to the circular arc-shaped interconnected pores corresponding thereto; In addition, two incisions are further formed on the rear axial end of the brush cover body, and the two incisions are matched with the two circular arc-shaped interconnected pores in one-to-one correspondence, and are interconnected.

As a further improvement of the present invention, on the outer peripheral side wall of the brush cover body and the portion between the two air inlet orifices respectively there is a circular arc-shaped second convex edge further extending radially outward, and the two second convex edges are located on the same radial plane, and the two second convex edges are both capable of abutting outside the front axial end face of the brush cover base.

As a further improvement of the present invention, the diversion base has a diversion base body, and the diversion base body is also a sleeve-shaped structure that is open at both ends of the axial direction, and on the outer peripheral side wall of the diversion base body, a plurality of annular grooves extending circumferentially along the diversion base body are disposed, and a plurality of the annular grooves is further arranged at equal intervals along the axial direction of the diversion base body; Further, on the outer peripheral side wall of the diversion base body, a second exhaust groove extending axially along the diversion base body is disposed, and the second exhaust groove is further corresponding to the incision and interconnected continuously;

In addition, a portion of the annular groove and the second exhaust groove are also interconnected continuously with the inner cavity of the diversion base body.

As a further improvement of the present invention, the container component comprises an outer bottle body, an inner bottle body and an inner plug. The outer bottle body is a sleeve-shaped structure with an open front side, and the inner bottle body is a sleeve-shaped structure body that is open at both ends of the axial direction, and the inner plug is sealed and connected to the rear axial side opening of the inner bottle body, and the inner bottle body is also coaxially inserted together with the inner plug;

In addition, the first portion of the brush cover base is inserted into the outer bottle body and screwed with the outer bottle body, and at the same time the rear axial end of the connection is also tightly inserted into the front axial side opening of the inner bottle body.

As a further improvement of the present invention, the cap component comprises an outer cover, an inner sleeve and a spring, the outer cover and the inner sleeve are both sleeve-shaped structures with the front axial side closed and the rear axial side open, and the inner sleeve and the spring are both built in the outer cover; and one end of the spring is also sleeved on the inner surface of the front axial side of the outer cover, and the other end of the spring is also sleeved on the front axial side of the inner sleeve;

In addition, a circuit of a fourth convex edge is formed radially outwardly at a position on the outer side wall of the inner sleeve and a circuit of a first convex edge is formed radially inwardly on the inner side wall of the outer cover, and the first convex edge can stop at the fourth convex edge.

As a further improvement of the present invention, the outer cover is sleeved outside the second portion of the brush cover base and is engaged with the second portion of the brush cover base; at the same time, the front axial side of the brush cover base also protrudes into the inner sleeve and abuts against the inner side wall of the inner sleeve.

The invention has the beneficial effects that: according to the prior art, the invention improves the structure of the brush cover, on the one hand, the first air exhaust groove is arranged on the brush cover body, and an air inlet orifice interconnected with the inner cavity of the brush cover body, and the first air exhaust groove is further connected to the air inlet orifice and the second exhaust groove on the diversion base, so that the air can pass through the "air inlet orifice, the first air exhaust groove, the circular arc-shaped interconnected pores, the incision, the second exhaust groove, the inner cavity of the brush cover body, the inner cavity of the connection, the liquid inlet orifice", entering into the inner bottle body, so that the pressure inside and outside of the liquid eyeliner is equal, so that in use, under the action of gravity, the eyeliner can flow into the bristles to stabilize the discharging of bristles; on the other hand, at least one liquid storage groove unit is provided on the inner peripheral sidewall of the brush cover body; each liquid storage groove unit consists of several circular arc-shaped liquid storage grooves extending along the circumference of the brush cover body; the several circular arc-shaped liquid storage grooves in each liquid storage groove unit are further arranged at intervals in the axial direction of the brush cover body. When the discharge amount is large, excessive eyeliner liquid is stored in the circular arc-shaped liquid storage grooves; when the discharge amount of bristles is insufficient, the eyeliner liquid in the liquid storage grooves is added to the bristles for supplementation, so that the discharge stability of the bristles is ensured.

### Brief description of the Drawings

Figure 1 is a schematic structural view of the liquid eyeliner according to the present invention;
Figure 2 is a schematic enlarged view of the coating component of the present invention;
Figure 3 is a schematic cross-sectional structural view of the brush cover of the present invention from one perspective;
Figure 4 is a schematic cross-sectional structural view of the brush cover of the present invention from another perspective.

With reference to the drawings, the following description is made:
1-container component 10-outer bottle body
11-inner bottle body 12-inner plug
2-coating component 20-brush cover base
21-brush cover 22-diversion base
23-connection 24-diversion core
25-bristles 200-first convex edge
210-brush cover body 211-air inlet orifice
212-first air exhaust groove 213-circular arc-shaped liquid storage grooves
214-circular arc-shaped interconnected pores 215-incision
216-second convex edge 220-annular grooves
230-liquid inlet holes 231-third convex edge
3-cap component 30-outer cover
31-inner sleeve 32-spring

### Detailed Description

A preferred embodiment of the present invention will be described in detail below with reference to the accompanying drawings. However, the scope of the present invention is not limited to the following embodiment, that is, the simple equivalent changes and modifications made by the scope of the present invention and the contents of the specification are still within the scope of the present invention as long as they fall within said scope as defined by the appended claims.

### Embodiment 1:

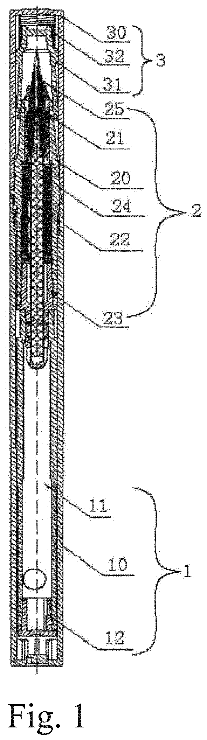

Please refer to figure 1 of the description, which is a schematic structural view of a liquid eyeliner according to the present invention. The liquid eyeliner having a liquid storage function, comprising a container component 1 for containing the liquid eyeliner, a coating component 2 for drawing and applying the eyeliner to the face of the user, and a cap component 3, wherein the coating component 2 has a brush cover base 20, a brush cover 21, a diversion base 22, a connection 23, a diversion core 24, and bristles 25 positioned and connected to one axial end of the diversion core; the brush cover base 20, the brush cover 21, the diversion base 22, and the connection 23 being coaxially disposed, and all are sleeve-shaped structures that are open at both ends of the axial direction, and the rear axial end of the brush cover 21 and the front axial end of the connection 23 are respectively correspondingly positioned and inserted into the front and rear axial ends of the brush cover base 20, and the diversion base 22 is disposed inside of the brush cover base 20, and located between the brush cover 21 and the connection 23, and at the same time the two axial ends of the diversion base 22 are also respectively abutted with the rear axial end of the brush cover 21 and the front axial end of the connection 23; in addition, the brush cover 21, the diversion base 22, and the connection 23 also collectively enclose a receiving cavity, the diversion core 24 together with the bristles 25 are all coaxial positioned and inserted into the receiving cavity, and a part of the bristles 25 also protrudes outside the front axial end of the brush cover 21; also extends radially outward at the outer side wall of the brush cover base 20 to form a circuit of a first convex edge 200; the first convex edge 200 divides the brush cover base 20 into a first portion corresponding to the connection 23, and a second portion corresponding to the brush cover 21, and the first portion of the brush cover base 20 is inserted into the container component 1, and is in a detachable positioning connection with the container component 1; the cap component 3 being detachably sleeved outside at the second portion of the brush cover base 20; characterized in that: the brush cover 21 has a brush cover body 210, wherein the brush cover body 210 is a sleeve-shaped structure that is open at both ends of the axial direction; at least one air inlet orifice 211 extending along the axial direction is formed at a position on the brush cover body 210 near the front axial end, and the front side of the air inlet orifice 211 is exposed outside the brush cover base 20; at least one first air exhaust groove 212 extending along the axial direction is formed on the outer peripheral side wall of the brush cover body 210, and the front side of the first air exhaust groove 212 is continuous with the air inlet orifice 211, and the rear side of the first air exhaust groove 212 is continuous with the second exhaust groove on the diversion base 22; in addition, at least one liquid storage groove unit is further disposed on an inner circumferential side wall of the brush cover body 210, and each of the liquid storage groove units is respectively composed of a plurality of circular arc-shaped liquid storage grooves 213 extending circumferentially along the brush cover body 210, and the several circular arc-shaped liquid storage grooves 213 in each liquid storage groove unit are further arranged at intervals in the axial direction of the brush cover body 210. Compared with the prior art, the present invention improves the structure of the brush cover, on the one hand, the first air exhaust groove is arranged on the brush cover body, and an air inlet orifice interconnected with the inner cavity of the brush cover body, and the first air exhaust groove is further connected to the air inlet orifice and the second exhaust groove on the diversion base, so that the air can pass through the "air inlet orifice, the first air exhaust groove, the circular arc-shaped interconnected pores, the incision, the second exhaust groove, the inner cavity of the brush cover body, the inner cavity of the connection, the liquid inlet orifice", entering into the inner bottle body, so that the pressure inside and outside of the liquid eyeliner is equal, so that in use, under the action of gravity, the eyeliner can flow into the bristles to stabilize the discharging of bristles; on the other hand, at least one liquid storage groove unit is provided on the inner peripheral sidewall of the brush cover body; each liquid storage groove unit consists of several circular arc-shaped liquid storage grooves extending along the circumference of the brush cover body; the several circular arc-shaped liquid storage grooves in each liquid storage groove unit are further arranged at intervals in the axial direction of the brush cover body. When the discharge amount is large, excessive eyeliner liquid is stored in the circular arc-shaped liquid storage grooves; when the discharge amount of bristles is insufficient, the eyeliner liquid in the liquid storage grooves is added to the bristles for supplementation, so that the discharge stability of the bristles is ensured. In addition, a circular arc-shaped groove extending along the circumferential direction of the brush cover is further formed at a position on the outer peripheral side wall of the brush cover body 210 and corresponding to each of the circular arc-shaped liquid storage grooves 213. A circular groove is provided to facilitate the flow of air between the brush cover and the brush cover base.

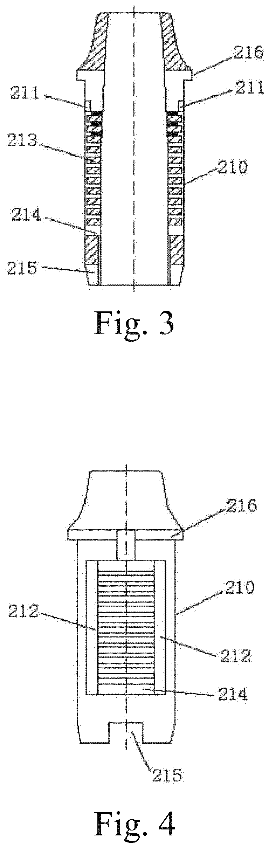

In the present invention, refer to figure 3-4, two liquid storage groove units are provided, a plurality of arc-shaped liquid storage grooves 213 of the two liquid storage groove units are symmetrically distributed around an axial center line of the brush cover body 210; two air inlet orifices 211 are provided, and the two air inlet orifices 211 are matched with the two liquid storage groove units in one-to-one correspondence, and each rear side of the air inlet orifice 211 further respectively extends to the front side of the liquid storage groove unit corresponding thereto.

Preferably, the exhaust groove 212 is disposed outside at the two circumferential sides of each liquid storage groove unit, and the rear sides of the two exhaust grooves 212 are continuously connected to the second exhaust groove of the diversion base 22.

A circular arc-shaped interconnected pore 214 extending along the circumferential direction of the brush cover body is further disposed at a position on the back side of each liquid storage groove unit on the brush cover body 210, and the rear side of the exhaust groove 212 is connected to the circular arc-shaped interconnected pores 214 corresponding thereto; In addition, two incisions 215 are further formed on the rear axial end of the brush cover body 210, and the two incisions 215 are matched with the two circular arc-shaped interconnected pores 214 in one-to-one correspondence, and are interconnected.

Further preferably, on the outer peripheral side wall of the brush cover body (210) and the portion between the two air inlet orifices 211 respectively there is a circular arc-shaped second convex edge 216 further extending radially outward, and the two second convex edges 216 are located on the same radial plane, and the two second convex edges 216 are both capable of abutting outside the front axial end face of the brush cover base 20.

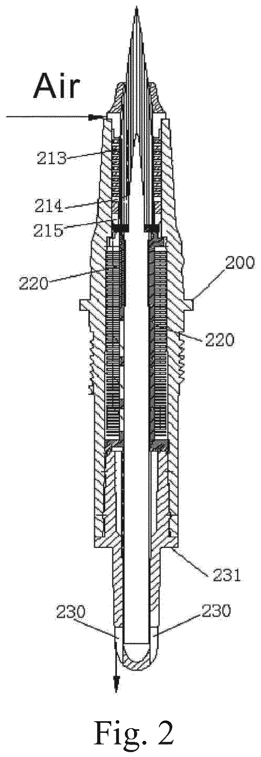

In the present invention, refer to Figure 2, the diversion base 22 has a diversion base body, and the diversion base body is also a sleeve-shaped structure that is open at both ends of the axial direction, and on the outer peripheral side wall of the diversion base body, a plurality of annular grooves 220 extending circumferentially along the diversion base body are disposed, and a plurality of the annular grooves 220 is further arranged at equal intervals along the axial direction of the diversion base body; further, on the outer peripheral side wall of the diversion base body, a second exhaust groove extending axially along the diversion base body is disposed, and the second exhaust groove is further corresponding to the incision (215) and interconnected continuously; in addition, a portion of the annular groove (220) and the second exhaust groove are also interconnected continuously with the inner cavity of the diversion base body, which can be realized by opening a through hole through the diversion base body.

In the present invention, the container component 1 comprises an outer bottle body 10, an inner bottle body 11 and an inner plug 12. The outer bottle body 10 is a sleeve-shaped structure with an open front side, and the inner bottle body 11 is a sleeve-shaped structure body that is open at both ends of the axial direction, and the inner plug 12 is sealed and connected to the rear axial side opening of the inner bottle body 11, and the inner bottle body 11 is also coaxially inserted together with the inner plug 12; In addition, the first portion of the brush cover base 20 is inserted into the outer bottle body 10 and screwed with the outer bottle body 10, and at the same time the rear axial end of the connection 23 is also tightly inserted into the front axial side opening of the inner bottle body 11.

In this embodiment, the connection 23 has a connection body which is a hollow cylinder body, and the front axial end of the connection body is open, and on the circumferential side wall of the connection body, and close to its rear axial end portion, two liquid inlet orifices 230 are formed. The two liquid inlet orifices are also open on the rear axial end surface of the connection body, and the two liquid inlet orifices 230 are also symmetrical; Form a circuit of a third convex edge 231 radially outwardly on the outer peripheral side wall of the outer cover 23. The third convex edge 231 divides the outer cover 23 into a first segment and a second segment, and the first segment is inserted into the rear axial end of the brush cover base 20 and is engaged with the brush cover base(The embodiment may be: providing a protrusion on the outer wall of the first segment, and providing a recess on the inner side wall of the brush cover base to engage with the protrusion); the second segment is tightly inserted in the front side opening of the inner bottle body 11, a snapping or screwing manner may be employed.

In the present embodiment, the cap component 3 comprises an outer cover 30, an inner sleeve 31 and a spring 32, the outer cover 30 and the inner sleeve 31 are both sleeve-shaped structures with the front axial side closed and the rear axial side open, and the inner sleeve 31 and the spring 32 are both built in the outer cover 30; and one end of the spring 32 is also sleeved on the inner surface of the front axial side of the outer cover 30, and the other end of the spring 32 is also sleeved on the front axial side of the inner sleeve 31 ;

In addition, a circuit of a fourth convex edge is formed radially outwardly at a position on the outer side wall of the inner sleeve 31 and a circuit of a first convex edge is formed radially inwardly on the inner side wall of the outer cover 30, and the first convex edge can stop at the fourth convex edge, and can prevent the inner sleeve 31 from being detached from the outer cover 30.

Preferably, the outer cover 30 is sleeved outside the second portion of the brush cover base 20 and is engaged with the second portion of the brush cover base 20; at the same time, the front axial side of the brush cover base 20 also protrudes into the inner sleeve 31 and abuts against the inner side wall of the inner sleeve 31, that is, the inner sleeve contacts the outer peripheral surface of the front side of the brush cover base to form a seal. In addition, the specific structure of the outer cover 30 being engaged with the second portion of the brush cover base 20 may be: forming a second protrusion on the outer side wall of the second portion of the brush cover base 20, a circular recess is recessed at a position on the inner side wall of the outer cover 30 near the rear axial side, and the second protrusion can be engaged with the recess; or a second recess can be formed on the outer side wall of the second portion of the brush cover base, and a circuit of a second protrusion is formed on the inner side wall of the outer cover 30.

## Claims

1. A liquid eyeliner having a liquid storage function, comprising a container component (1) for containing the eyeliner liquid, a coating component (2) for drawing and applying the eyeliner liquid to the face of a user, and a cap component (3), wherein the coating component (2) has a brush cover base (20), a brush cover (21), a diversion base (22), a connection (23), a diversion core (24), and bristles (25) positioned and connected to one axial end of the diversion core; the brush cover base (20), the brush cover (21), the diversion base (22), and the connection (23) being coaxially disposed, and all are sleeve-shaped structures that are open at both ends of the axial direction, and the rear axial end of the brush cover (21) and the front axial end of the connection (23) are respectively correspondingly positioned and inserted into the front and rear axial ends of the brush cover base (20), and the diversion base (22) is disposed inside of the brush cover base (20), and located between the brush cover (21) and the connection (23), and at the same time the two axial ends of the diversion base (22) are also respectively abutted with the rear axial end of the brush cover (21) and the front axial end of the connection (23); in addition, the brush cover (21), the diversion base (22), and the connection (23) also collectively enclose a receiving cavity, the diversion core (24) together with the bristles (25) are all coaxial positioned and inserted into the receiving cavity, and a part of the bristles (25) also protrudes outside the front axial end of the brush cover (21); also a circuit of a first convex edge (200) extends radially outward at the outer side wall of the brush cover base (20); the first convex edge (200) divides the brush cover base (20) into a first portion corresponding to the connection (23), and a second portion corresponding to the brush cover (21), and the first portion of the brush cover base (20) is inserted into the container component (1), and is in a detachable positioning connection with the container component (1); the cap component (3) being detachably sleeved outside at the second portion of the brush cover base (20); the brush cover (21) has a brush cover body (210), wherein the brush cover body (210) is a sleeve-shaped structure that is open at both ends of the axial direction;
**characterized in that** at least one air inlet orifice (211) extending along the axial direction is formed at a position on the brush cover body (210) near the front axial end, and the front side of the air inlet orifice (211) is exposed outside the brush cover base (20); at least one first air exhaust groove (212) extending along the axial direction is formed on the outer peripheral side wall of the brush cover body (210), and the front side of the first air exhaust groove (212) is continuous with the air inlet orifice (211), and the rear side of the first air exhaust groove (212) is continuous with a second exhaust groove on the diversion base (22); in addition, at least one liquid storage groove unit is further disposed on an inner circumferential side wall of the brush cover body (210), and each of the liquid storage groove units is respectively composed of a plurality of circular arc-shaped liquid storage grooves(213) extending circumferentially along the brush cover body (210), and the several circular arc-shaped liquid storage grooves (213) in each liquid storage groove unit are further arranged at intervals in the axial direction of the brush cover body (210).

2. The liquid eyeliner having a liquid storage function according to claim 1, **characterized in that**:
two liquid storage groove units are provided, a plurality of arc-shaped liquid storage grooves (213) of the two liquid storage groove units are symmetrically distributed around an axial center line of the brush cover body (210); two air inlet orifices (211) are provided, and the two air inlet orifices (211) are matched with the two liquid storage groove units in one-to-one correspondence, and each rear side of the air inlet orifice (211) further respectively extends to the front side of the liquid storage groove unit corresponding thereto.

3. The liquid eyeliner having a liquid storage function according to claim 2, **characterized in that**:
the exhaust groove (212) is disposed outside at the two circumferential sides of each liquid storage groove unit, and the rear sides of the two exhaust grooves (212) are continuously connected to the second exhaust groove of the diversion base (22); a circular arc-shaped interconnected pore (214) extending along the circumferential direction of the brush cover body is further disposed at a position on the back side of each liquid storage groove unit on the brush cover body (210), and the rear side of the exhaust groove (212) is connected to the circular arc-shaped interconnected pores (214) corresponding thereto; in addition, two incisions (215) are further formed on the rear axial end of the brush cover body (210), and the two incisions (215) are matched with the two circular arc-shaped interconnected pores (214) in one-to-one correspondence, and are interconnected.

4. The liquid eyeliner having a liquid storage function according to claim 2, **characterized in that**:
on the outer peripheral side wall of the brush cover body (210) and the portion between the two air inlet orifices (211) respectively a circular arc-shaped second convex edge (216) further extends radially outward, and the two second convex edges (216) are located on the same radial plane, and the two second convex edges (216) are both capable of abutting outside the front axial end face of the brush cover base (20).

5. The liquid eyeliner having a liquid storage function according to claim 3, **characterized in that**:
the diversion base (22) has a diversion base body, and the diversion base body is also a sleeve-shaped structure that is open at both ends of the axial direction, and on the outer peripheral side wall of the diversion base body, a plurality of annular grooves (220) extending circumferentially along the diversion base body are disposed, and a plurality of the annular grooves (220) is further arranged at equal intervals along the axial direction of the diversion base body; further, on the outer peripheral side wall of the diversion base body, a second exhaust groove extending axially along the diversion base body is disposed, and the second exhaust groove is further corresponding to the incision (215) and interconnected continuously;
in addition, a portion of the annular groove (220) and the second exhaust groove are also interconnected continuously with the inner cavity of the diversion base body.

6. The liquid eyeliner having a liquid storage function according to claim 1, **characterized in that**:
the container component (1) comprises an outer bottle body (10), an inner bottle body (11) and an inner plug (12); the outer bottle body (10) is a sleeve-shaped structure with an open front side, and the inner bottle body (11) is a sleeve-shaped structure body that is open at both ends of the axial direction, and the inner plug (12) is sealed and connected to the rear axial side opening of the inner bottle body (11), and the inner bottle body (11) is also coaxially inserted together with the inner plug (12); in addition, the first portion of the brush cover base (20) is inserted into the outer bottle body (10) and screwed with the outer bottle body (10), and at the same time the rear axial end of the connection (23) is also tightly inserted into the front axial side opening of the inner bottle body (11).

7. The liquid eyeliner having a liquid storage function according to claim 1, **characterized in that**:
the cap component (3) comprises an outer cover (30), an inner sleeve (31) and a spring (32), the outer cover (30) and the inner sleeve (31) are both sleeve-shaped structures with the front axial side closed and the rear axial side open, and the inner sleeve (31) and the spring (32) are both built in the outer cover (30); and one end of the spring (32) is also sleeved on the inner surface of the front axial side of the outer cover (30), and the other end of the spring (32) is also sleeved on the front axial side of the inner sleeve (31); in addition, a circuit of a fourth convex edge is formed radially outwardly at a position on the outer side wall of the inner sleeve (31) and a circuit of a first convex edge is formed radially inwardly on the inner side wall of the outer cover (30), and the first convex edge can stop at the fourth convex edge.

8. The liquid eyeliner having a liquid storage function according to claim 7, **characterized in that**:
the outer cover (30) is sleeved outside the second portion of the brush cover base (20) and is engaged with the second portion of the brush cover base (20); at the same time, the front axial side of the brush cover base (20) also protrudes into the inner sleeve (31) and abuts against the inner side wall of the inner sleeve (31).

## Patentansprüche

1. Flüssiger Eyeliner, der eine Flüssigkeitsspeicherfunktion aufweist, umfassend eine Behälterkomponente (1) zum Enthalten einer Eyeliner-Flüssigkeit, eine Bedeckungskomponente (2) zum Zeichnen und Auftragen der Eyeliner-Flüssigkeit auf das Gesicht eines Nutzers, und eine Kappenkomponente (3), wobei die Bedeckungskomponente (2) eine Bürstenabdeckungsbasis (20), eine Bürstenabdeckung (21), eine Umlenkungsbasis (22), eine Verbindung (23), einen Umlenkungskern (24), und Borsten (25) aufweist, die an einem axialen Ende des Umlenkungskerns positioniert, und damit verbunden sind; wobei die Bürstenabdeckungsbasis (20), die Bürstenabdeckung (21), die Umlenkungsbasis (22) und die Verbindung (23) koaxial angeordnet sind, und alle hülsenförmige Strukturen sind, die an beiden Enden der axialen Richtung offen sind, und das hintere axiale Ende der Bürstenabdeckung (21) und das vordere axiale Ende der Verbindung (23) jeweils entsprechend positioniert, und in die vorderen und hinteren axialen Enden der Bürstenabdeckungsbasis (20) eingeführt sind, und die Umlenkungsbasis (22) innerhalb der Bürstenabdeckungsbasis (20) angeordnet ist, und zwischen der Bürstenabdeckung (21) und der Verbindung (23) gelegen ist, und die beiden axialen Enden der Umlenkungsbasis (22) gleichzeitig auch jeweils an dem hinteren axialen Ende der Bürstenabdeckung (21) und dem vorderen axialen Ende der Verbindung (23) anliegen; zusätzlich schließen die Bürstenabdeckung (21), die Umlenkungsbasis (22) und die Verbindung (23) auch gemeinsam einen Aufnahmehohlraum ein, der Umlenkungskern (24) ist gemeinsam mit den Borsten (25) allesamt koaxial in dem Aufnahmehohlraum positioniert und darin eingeführt, und ein Teil der Borsten (25) steht auch außerhalb des vorderen axialen Endes der Bürstenabdeckung (21) hervor; auch ein Kreis einer ersten konvexen Kante (200) erstreckt sich an der äußeren Seitenwand der Bürstenabdeckungsbasis (20) radial nach außen; die erste konvexe Kante (200) teilt die Bürstenabdeckungsbasis (20) in einen ersten Abschnitt entsprechend der Verbindung (23), und einen zweiten Abschnitt entsprechend der Bürstenabdeckung (21), und der erste Abschnitt der Bürstenabdeckungsbasis (20) wird in die Behälterkomponente (1) eingeführt, und ist in einer trennbaren Positionierungsverbindung mit der Behälterkomponente (1); wobei die Kappenkomponente (3) außerhalb an dem zweiten Abschnitt der Bürstenabdeckungsbasis (20) trennbar ummantelt ist; die Bürstenabdeckung (21) einen Bürstenabdeckungskörper (210) aufweist, wobei der Bürstenabdeckungskörper (210) eine hülsenförmige Struktur ist, die an beiden Enden der axialen Richtung offen ist;
**dadurch gekennzeichnet, dass** mindestens eine Lufteinlassöffnung (211), die sich entlang der axialen Richtung erstreckt, in einer Position auf dem Bürstenabdeckungskörper (210) nahe dem vorderen axialen Ende gebildet ist, und die Vorderseite der Lufteinlassöffnung (211) außerhalb der Bürstenabdeckungsbasis (20) freiliegend ist; sich mindestens eine Luftauslassnut (212), die sich entlang der axialen Richtung erstreckt, an der umfänglichen äußeren Seitenwand des Bürstenabdeckungskörpers (210) gebildet ist, und die Vorderseite der Luftauslassnut (212) durchgängig mit der Lufteinlassöffnung (211) ist, und die Rückseite der ersten Luftauslassnut (212) durchgängig mit einer zweiten Auslassnut auf der Umlenkungsbasis (22) ist; zusätzlich ist mindestens eine Flüssigkeitsspeichernuteinheit weiter an einer umfänglichen inneren Seitenwand des Bürstenabdeckungskörpers (210) angeordnet, und jede der Flüssigkeitsspeichernuteinheiten setzt sich jeweils aus einer Vielzahl von runden bogenförmigen Flüssigkeitsspeichernuten (213) zusammen, die sich umfänglich entlang des Bürstenabdeckungskörpers (210) erstrecken, und die verschiedenen runden bogenförmigen Flüssigkeitsspeichernuten (213) in jeder Flüssigkeitsspeichernuteinheit sind weiter in Intervallen in der axialen Richtung des Bürstenabdeckungskörpers (210) angeordnet.

2. Flüssiger Eyeliner, der eine Flüssigkeitsspeicherfunktion aufweist, nach Anspruch 1, **dadurch gekennzeichnet, dass**: zwei Flüssigkeitsspeichernuteinheiten bereitgestellt sind, eine Vielzahl von bogenförmigen Flüssigkeitsspeichernuten (213) der beiden Flüssigkeitsspeichernuteinheiten symmetrisch um eine axiale Mittellinie des Bürstenabdeckungskörpers (210) verteilt sind; zwei Lufteinlassöffnungen (211) bereitgestellt sind, und die beiden Lufteinlassöffnungen (211) zu den beiden Flüssigkeitsspeichernuteinheiten in einer Eins-zu-Eins Entsprechung passend sind, und jede Rückseite der Lufteinlassöffnung (211) sich weiter jeweils zur Vorderseite der dazu entsprechenden Flüssigkeitsspeichernuteinheit erstreckt.

3. Flüssiger Eyeliner, der eine Flüssigkeitsspeicherfunktion aufweist, nach Anspruch 2, **dadurch gekennzeichnet, dass**: die Auslassnut (212) außerhalb der beiden Umfangsseiten jeder Flüssigkeitsspeichernuteinheit angeordnet ist, und die Rückseiten der beiden Auslassnuten (212) durchgehend mit der zweiten Auslassnut der Umlenkungsbasis (22) verbunden sind; eine runde, bogenförmige vernetzte Pore (214), die sich entlang der Umfangsrichtung des Bürstenabdeckkörpers erstreckt, weiter in einer Position auf der Rückseite jeder Flüssigkeitsspeichernuteinheit auf dem Bürstenabdeckungskörper (210) angeordnet ist, und die Rückseite der Auslassnut (212) mit den runden, bogenförmigen vernetzten Poren (214), die diesen entsprechen, verbunden ist; zusätzlich sind zwei Einschnitte (215) weiter an dem hinteren axialen Ende des Bürstenabdeckungskörpers (210) gebildet, und die beiden Einschnitte (215) sind zu den runden, bogenförmigen vernetzten Poren (214) in einer Eins-zu-Eins Entsprechung passen, und sind miteinander vernetzt.

4. Flüssiger Eyeliner, der eine Flüssigkeitsspeicherfunktion aufweist, nach Anspruch 2, **dadurch gekennzeichnet, dass**: sich an der umfänglichen äußeren Seitenwand des Bürstenabdeckungskörpers (210) und dem Abschnitt zwischen den beiden Lufteinlassöffnungen (211) jeweils eine runde, bogenförmige zweite konvexe Kante (16) radial nach außen erstreckt, und sich die beiden zweiten konvexen Kanten (216) auf derselben radialen Ebene befinden und die beiden konvexen Kanten (216) beide imstande sind, außerhalb der vorderen axialen Endfläche der Bürstenabdeckungsbasis (20) anzuliegen.

5. Flüssiger Eyeliner, der eine Flüssigkeitsspeicherfunktion aufweist, nach Anspruch 3, **dadurch gekennzeichnet, dass**: die Umlenkungsbasis (22) einen Umlenkungsbasiskörper aufweist, und der Umlenkungsbasiskörper auch eine hülsenförmige Struktur ist, die an beiden Enden der axialen Richtung und an der umfänglichen äußeren Seitenwand des Umlenkungsbasiskörpers offen ist, wobei sich eine Vielzahl von runden Nuten (220), die sich umfänglich entlang des Umlenkungsbasiskörpers erstrecken, angeordnet sind, und eine Vielzahl der runden Nuten (220) weiter in gleichen Intervallen entlang der axialen Richtung des Umlenkungsbasiskörpers angeordnet ist; wobei sich weiter an der umfänglichen äußeren Seitenwand des Umlenkungsbasiskörpers eine zweite Auslassnut, die sich axial entlang des Umlenkungsbasiskörpers erstreckt, angeordnet ist, und die zweite Auslassnut weiter dem Einschnitt (215) entspricht und durchgehend vernetzt ist; zusätzlich ein Abschnitt der runden Nut (220) und die zweite Auslassnut auch durchgehend mit dem inneren Hohlraum des Umlenkungsbasiskörpers vernetzt sind.

6. Flüssiger Eyeliner, der eine Flüssigkeitsspeicherfunktion aufweist, nach Anspruch 1, **dadurch gekennzeichnet, dass**: die Behälterkomponente (1) einen äußeren Flaschenkörper (10), einen inneren Flaschenkörper (11) und einen inneren Stopfen (12) umfasst; der äußere Flaschenkörper (10) eine hülsenförmige Struktur mit einer offenen Vorderseite ist, und der innere Flaschenkörper (11) ein hülsenförmiger Strukturkörper ist, der an beiden Enden der axialen Richtung offen ist, und der innere Stopfen (12) an der axialen rückseitigen Öffnung des inneren Flaschenkörpers (11) abgedichtet und verbunden ist, und der innere Flaschenkörper (11) auch koaxial gemeinsam mit dem inneren Stopfen (12) eingeführt ist; zusätzlich ist der erste Abschnitt der Bürstenabdeckungsbasis (20) in den äußeren Flaschenkörper (10) eingeführt und mit dem äußeren Flaschenkörper (10) verschraubt, und das hintere axiale Ende der Verbindung (23) ist gleichzeitig auch dicht in die axiale vorderseitige Öffnung des inneren Flaschenkörpers (11) eingeführt.

7. Flüssiger Eyeliner, der eine Flüssigkeitsspeicherfunktion aufweist, nach Anspruch 1, **dadurch gekennzeichnet, dass**: die Kappenkomponente (3) eine äußere Abdeckung (30), eine innere Hülse (31) und eine Feder (32) umfasst, wobei die äußere Abdeckung (30) und die innere Hülse (31) beide hülsenförmige Strukturen mit der axialen Vorderseite verschlossen und der axialen Rückseite offen sind, und die innere Hülse (31) und die Feder (32) beide in der äußeren Abdeckung (30) eingebaut sind; und ein Ende der Feder (32) auch an der Innenoberfläche der axialen Vorderseite der äußeren Abdeckung (30) ummantelt ist, und das andere Ende der Feder (32) auch an der axialen Vorderseite der inneren Hülse (31) ummantelt ist; zusätzlich ist ein Kreis einer vierten konvexen Kante radial außerhalb in einer Position an der äußeren Seitenwand der inneren Hülse (31) gebildet, und ein Kreis einer ersten konvexen Kante ist radial innerhalb der inneren Seitenwand der äußeren Abdeckung (30) gebildet, und die erste konvexe Kante kann an der vierten konvexen Kante enden.

8. Flüssiger Eyeliner, der eine Flüssigkeitsspeicherfunktion aufweist, nach Anspruch 7, **dadurch gekennzeichnet, dass**: die äußere Abdeckung (30) außerhalb des zweiten Abschnitts der Bürstenabdeckungsbasis (20) ummantelt ist, und in den zweiten Abschnitt der Bürstenabdeckungsbasis (20) eingreift; und gleichzeitig die axiale Vorderseite der Bürstenabdeckungsbasis (20) auch in die innere Hülse vorsteht und an der inneren Seitenwand der inneren Hülse (31) anliegt.

## Revendications

1. Ligneur liquide ayant une fonction de stockage de liquide, comprenant un composant de contenant (1) pour contenir le liquide de ligneur, un composant de revêtement (2) pour attirer et appliquer le liquide de ligneur sur le visage d'un utilisateur, et un composant de capuchon (3), dans lequel le composant de revêtement (2) a une base de couverture de pinceau (20), une couverture de pinceau (21), une base de déviation (22), un raccordement (23), une âme de déviation (24), et des poils (25) positionnés et raccordés à une extrémité axiale de l'âme de déviation ; la base de couverture de pinceau (20), la couverture de pinceau (21), la base de déviation (22), et le raccordement (23) étant disposés de manière coaxiale, et tous sont des structures en forme de manchon qui sont ouvertes aux deux extrémités de la direction axiale, et l'extrémité axiale arrière de la couverture de pinceau (21) et l'extrémité axiale avant du raccordement (23) sont positionnées de manière respectivement correspondante et insérées dans les extrémités axiales avant et arrière de la base de couverture de pinceau (20), et la base de déviation (22) est disposée à l'intérieur de la base de couverture de pinceau (20), et située entre la couverture de pinceau (21) et le raccordement (23), et dans le même temps les deux extrémités axiales de la base de déviation (22) sont également mises en butée respectivement avec l'extrémité axiale arrière de la couverture de pinceau (21) et l'extrémité axiale avant du raccordement (23) ; de plus, la couverture de pinceau (21), la base de déviation (22), et le raccordement (23) enserrent également collectivement une cavité de réception, l'âme de déviation (24) ainsi que les poils (25) sont tous positionnés de manière coaxiale et insérés dans la cavité de réception, et une partie des poils (25) fait également saillie à l'extérieur de l'extrémité axiale avant de la couverture de pinceau (21) ; de plus un circuit d'un premier bord convexe (200) s'étend radialement vers l'extérieur au niveau de la paroi de côté externe de la base de couverture de pinceau (20) ;
le premier bord convexe (200) divise la base de couverture de pinceau (20) en une première portion correspondant au raccordement (23), et une deuxième portion correspondant à la couverture de pinceau (21), et la première portion de la base de couverture de pinceau (20) est insérée dans le composant de contenant (1), et est dans un raccordement de positionnement détachable avec le composant de contenant (1) ; le composant de capuchon (3) étant manchonné de manière détachable à l'extérieur au niveau de la deuxième portion de la base de couverture de pinceau (20) ; la couverture de pinceau (21) a un corps de couverture de pinceau (210), dans lequel le corps de couverture de pinceau (210) est une structure en forme de manchon qui est ouverte aux deux extrémités de la direction axiale ;
**caractérisé en ce qu'**au moins un orifice d'entrée d'air (211) s'étendant suivant la direction axiale est formé à une position sur le corps de couverture de pinceau (210) proche de l'extrémité axiale avant, et le côté avant de l'orifice d'entrée d'air (211) est exposé à l'extérieur de la base de couverture de pinceau (20) ; au moins une première rainure d'échappement d'air (212) s'étendant suivant la direction axiale est formée sur la paroi de côté périphérique externe du corps de couverture de pinceau (210), et le côté avant de la première rainure d'échappement d'air (212) est continu avec l'orifice d'entrée d'air (211), et le côté arrière de la première rainure d'échappement d'air (212) est continu avec une deuxième rainure d'échappement dans la base de déviation (22) ; de plus, au moins une unité de rainure de stockage de liquide est en outre disposée sur une paroi de côté circonférentielle interne du corps de couverture de pinceau (210), et chacune des unités de rainure de stockage de liquide est respectivement composée d'une pluralité de rainures de stockage de liquide en forme d'arc circulaire (213) s'étendant circonférentiellement suivant le corps de couverture de pinceau (210), et les différentes rainures de stockage de liquide en forme d'arc circulaire (213) dans chaque unité de rainure de stockage de liquide sont en outre agencées à intervalles dans la direction axiale du corps de couverture de pinceau (210).

2. Ligneur liquide ayant une fonction de stockage de liquide selon la revendication 1, **caractérisé en ce que** :
deux unités de rainure de stockage de liquide sont prévues, une pluralité de rainures de stockage de liquide en forme d'arc (213) des deux unités de rainure de stockage de liquide sont réparties symétriquement autour d'une ligne de centre axial du corps de couverture de pinceau (210) ;
deux orifices d'entrée d'air (211) sont prévus, et les deux orifices d'entrée d'air (211) sont mis en concordance avec les deux unités de rainure de stockage de liquide en correspondance biunivoque, et chaque côté arrière de l'orifice d'entrée d'air (211) s'étend en outre respectivement jusqu'au côté avant de l'unité de rainure de stockage de liquide qui lui correspond.

3. Ligneur liquide ayant une fonction de stockage de liquide selon la revendication 2, **caractérisé en ce que** :
la rainure d'échappement (212) est disposée à l'extérieur au niveau des deux côtés circonférentiels de chaque unité de rainure de stockage de liquide, et les côtés arrière des deux rainures d'échappement (212) sont raccordés en continu à la deuxième rainure d'échappement de la base de déviation (22) ; un pore (214) raccordé mutuellement en forme d'arc circulaire s'étendant suivant la direction circonférentielle du corps de couverture de pinceau est en outre disposé à une position sur le côté de dos de chaque unité de rainure de stockage de liquide sur le corps de couverture de pinceau (210), et le côté arrière de la rainure d'échappement (212) est raccordé aux pores (214) raccordés mutuellement en forme d'arc circulaire qui lui correspondent ; de plus, deux incisions (215) sont en outre formées sur l'extrémité axiale arrière du corps de couverture de pinceau (210), et les deux incisions (215) sont mises en concordance avec les deux pores (214) raccordés mutuellement en forme d'arc circulaire en correspondance biunivoque, et sont raccordées entre elles.

4. Ligneur liquide ayant une fonction de stockage de liquide selon la revendication 2, **caractérisé en ce que** :
sur la paroi de côté périphérique externe du corps de couverture de pinceau (210) et la portion entre les deux orifices d'entrée d'air (211) respectivement un deuxième bord convexe en forme d'arc circulaire (216) s'étend en outre radialement vers l'extérieur, et les deux deuxièmes bords convexes (216) sont situés sur le même plan radial, et les deux deuxièmes bords convexes (216) sont tous deux capables de venir en butée à l'extérieur de la face d'extrémité axiale avant de la base de couverture de pinceau (20).

5. Ligneur liquide ayant une fonction de stockage de liquide selon la revendication 3, **caractérisé en ce que** :
la base de déviation (22) a un corps de base de déviation, et le corps de base de déviation est également une structure en forme de manchon qui est ouverte aux deux extrémités de la direction axiale, et sur la paroi de côté périphérique externe du corps de base de déviation, une pluralité de rainures annulaires (220) s'étendant circonférentiellement suivant le corps de base de déviation sont disposées, et une pluralité des rainures annulaires (220) est en outre agencée à intervalles égaux suivant la direction axiale du corps de base de déviation ;
en outre, sur la paroi de côté périphérique externe du corps de base de déviation, une deuxième rainure d'échappement s'étendant axialement suivant le corps de base de déviation est disposée, et la deuxième rainure d'échappement est en outre correspondante à l'incision (215) et raccordée mutuellement en continu ; de plus, une portion de la rainure annulaire (220) et la deuxième rainure d'échappement sont également raccordées mutuellement en continu avec la cavité interne du corps de base de déviation.

6. Ligneur liquide ayant une fonction de stockage de liquide selon la revendication 1, **caractérisé en ce que** :
le composant de contenant (1) comprend un corps de flacon externe (10), un corps de flacon interne (11) et un bouchon interne (12) ; le corps de flacon externe (10) est une structure en forme de manchon avec un côté avant ouvert, et le corps de flacon interne (11) est un corps de structure en forme de manchon qui est ouvert aux deux extrémités de la direction axiale, et le bouchon interne (12) est scellé et raccordé à l'ouverture de côté axial arrière du corps de flacon interne (11), et le corps de flacon interne (11) est également inséré de manière coaxiale conjointement avec le bouchon interne (12) ; de plus, la première portion de la base de couverture de pinceau (20) est insérée dans le corps de flacon externe (10) et vissée avec le corps de flacon externe (10), et dans le même temps l'extrémité axiale arrière du raccordement (23) est également insérée de manière étanche dans l'ouverture de côté axial avant du corps de flacon interne (11).

7. Ligneur liquide ayant une fonction de stockage de liquide selon la revendication 1, **caractérisé en ce que** :
le composant de capuchon (3) comprend une couverture externe (30), un manchon interne (31) et un ressort (32), la couverture externe (30) et le manchon interne (31) sont tous deux des structures en forme de manchon avec le côté axial avant fermé et le côté axial arrière ouvert, et le manchon interne (31) et le ressort (32) sont tous deux intégrés dans la couverture externe (30) ; et une extrémité du ressort (32) est également manchonnée sur la surface interne du côté axial avant de la couverture externe (30), et l'autre extrémité du ressort (32) est également manchonnée sur le côté axial avant du manchon interne (31) ; de plus, un circuit d'un quatrième bord convexe est formé radialement vers l'extérieur à une position sur la paroi de côté externe du manchon interne (31) et un circuit d'un premier bord convexe est formé radialement vers l'intérieur sur la paroi de côté interne de la couverture externe (30), et le premier bord convexe peut s'arrêter au niveau du quatrième bord convexe.

8. Ligneur liquide ayant une fonction de stockage de liquide selon la revendication 7, **caractérisé en ce que** :
la couverture externe (30) est manchonnée à l'extérieur de la deuxième portion de la base de couverture de pinceau (20) et est engagée avec la deuxième portion de la base de couverture de pinceau (20) ; dans le même temps, le côté axial avant de la base de couverture de pinceau (20) fait également saillie dans le manchon interne (31) et bute contre la paroi de côté interne du manchon interne (31).
